# EUROPÄISCHE PATENTSCHRIFT

(11) **EP 0 570 609 B1**
(45) Veröffentlichungstag und Bekanntmachung des Hinweises auf die Patenterteilung: **03.11.1999**
(21) Anmeldenummer: 92108484.4
(22) Anmeldetag: 20.05.1992
(51) Int. Cl.: G03F 7/00, H01L 21/033

(54) **Verfahren zum Erzeugen einer mehrstufigen Struktur in einem Substrat**
Process for producing multistep structure in a substrate
Procédé pour fabriquer une structure en échelon dans un substrat

(43) Veröffentlichungstag der Anmeldung: 24.11.1993
(73) Patentinhaber: International Business Machines Corporation, Armonk, N.Y. 10504 (US)
(72) Erfinder: Bartha, Johann, Dr., W-7042 Aidlingen- Dachtel (DE); Greschner, Johann, Dr., W-7401 Pliezhausen 1 (DE); Probst, Karl-Heinz, Dr., W-7014 Kornwestheim (DE); Schmid, Gerhard, Dr., W-7022 Leinfelden/Echterdingen 3 (DE)
(74) Vertreter: Rach, Werner, Dr.

(56) Entgegenhaltungen:
- EP-A- 0 217 071
- EP-A- 0 286 855
- WO-A-87/02179
- DE-A- 3 015 572
- US-A- 4 124 473
- IBM TECHNICAL DISCLOSURE BULLETIN. Bd. 32, Nr. 8A, Januar 1990, NEW YORK US Seiten 218 - 219 'Method to incorporate three sets of pattern information in two photomasking steps'

## Beschreibung

Die Erfindung betrifft ein Verfahren zum Erzeugen einer mehrstufigen Struktur in einem Substrat.

In vielen Bereichen der Technik ist es erforderlich, in einem Substrat eine stufige Struktur zu erzeugen. Soll diese Struktur einstufig sein, so wird sie in der Regel durch Entfernen von Substrat, z.B. mit mechanischen, physikalischen oder chemischen Verfahren, erzeugt. Bei größeren Stückzahlen mit höheren Anforderungen an die Präzision werden häufig Fotoprozesse eingesetzt, um die Position der Stufe auf dem Substrat zu definieren. Hierbei wird entweder eine fotoaktive Substanz auf die Struktur aufgetragen, durch eine Maske belichtet, entwickelt und dadurch Gebiete für das Entfernen von Substrat passiviert oder das Entfernen von Substrat erfolgt durch eine Maske, die während des Entfernens über dem Substrat angeordnet wird.

Handelt es sich nun um die Herstellung einer mehrstufigen Struktur, so wird üblicherweise sequentiell verfahren: Es wird zunächst eine einstufige Struktur erstellt und dann in der ersten Stufe weitere Stufen erzeugt. Dies setzt allerdings voraus, daß die erste Stufe gleichmäßig tief in das Substrat eingebracht ist, da sonst die dort vorhandenen Unregelmäßigkeiten in die nächsten Stufen übertragen werden. Außerdem bringt dieses Vorgehen Schwierigkeiten beim Plazieren der zweiten Fotomaske und Ungenauigkeiten beim Einbringen der zweiten Stufe in das Substrat mit sich. Somit kommt diese Vorgehen nur bei Stufen einer gewissen Größe bei nicht allzu großen Präzisionsanforderungen in Frage.

Bei der Herstellung von Bauteilen für die Computerindustrie werden solche stufigen Strukturen häufig verwendet. Dies ist z.B. bei den sogenannten Verdrahtungsebenen von Halbleiterchips oder auch bei der Dünnfilm-Verdrahtung auf Vielschicht-Keramiksubstraten der Fall.

Mit der fortschreitenden Miniaturisierung solcher Bauteile bei steigenden Genauigkeitsanforderungen wurden die Grenzen des oben geschilderten Verfahrens erreicht und ein neues Konzept für das Herstellen solcher Strukturen mußte gefunden werden.

Aus dem IBM Technical Disclosure Bulletin, Vol. 33, No. 2, July 1990, S. 447, "Dual-Image Resist for Single-Exposure Self-Aligned Processing" ist ein Fotoresistsystem, bestehend aus einem naß zu entwickelnden ersten und einem trocken zu entwickelnden zweiten Fotoresist, die bei unterschiedlichen Wellenlängen belichtet werden, bekannt. Mit einem solchen System können stufenförmige Strukturen aus einem Substrat herausgearbeitet werden, indem zunächst bei einer Wellenlänge belichtet und entwickelt wird und nach Abarbeiten dieser ersten Öffnung in der Fotoresistschicht eine zweite Belichtung, gefolgt von einer zweiten Entwicklung und einem zweiten Abarbeiten, stattfindet. Dies hat jedoch insoweit Grenzen, als solche auf verschiedene Wellenlängen reagierende Fotoresists teuer sind, nicht beliebig viele Stufen damit realisiert werden können und die dabei erreichbare Präzision von der Empfindlichkeit des zweiten Fotoresists gegenüber der ersten Wellenlänge abhängt.

Die Erfindung hat somit zur Aufgabe, ein preiswertes Verfahren zu entwickeln, mit dem feinste mehrstufige Strukturen mit großer Präzision in einem Substrat erzeugt werden können.

Diese Aufgabe wird erfindungsgemäß durch ein Verfahren mit folgenden Verfahrensschritten gelöst:
a.) Herstellen eines Substrates (1);
b.) Auftragen einer ersten Fotoresistschicht (2) auf das Substrat (1);
c.) Erzeugen einer ersten Öffnung (4) in der ersten Fotoresistschicht (2) durch Belichten durch eine erste Maske (3), Entwickeln und Post-Bake der ersten Fotoresistschicht (2);
d.) Auftragen einer zweiten Fotoresistschicht (5) auf die erste Fotoresistschicht (2) und auf das Substrat (1) im Bereich der ersten Öffnung (4) wobei mindestens eine der Fotoresistschichten (2,5) aus Fotoresist besteht, der nach dem Auftragen silyliert wird oder daß mindestens einer der Fotoresistschichten als silylierter Fotoresist aufgetragen wird.
e.) Erzeugen einer zweiten Öffnung (7) in der zweiten Fotoresistschicht (5) durch Belichten durch eine zweite Maske (6), Entwickeln und Post-Bake, wobei die zweite Öffnung (7) über der ersten Öffnung (4) angeordnet und größer als die erste Öffnung (4) ist;
f.) Übertragen der ersten Öffnung (4) in das Substrat (1);
g.) Entfernen der ersten Fotoresistschicht (2), soweit diese nicht von darüberliegender zweiter Fotoresistschicht (5) bedeckt war und gleichzeitiges Entfernen der obersten Fotoresistschicht (5);
h.) Übertragen der zweiten Öffnung (7) in das Substrat (1) und gleichzeitig Vertiefen der ersten Öffnung (4) in dem Substrat (1);
i.) Entfernen der ersten Fotoresistschicht (2).

Durch dieses Verfahren wird das Topographieproblem, das beim Erzeugen von Strukturen mit feinsten vertikalen Stufen in einem Substrat zwangsläufig auftritt, auf dünne, auf der glatten Substratoberfläche aufzubringende Schichten, die dann sequentiell abgearbeitet werden, verlagert.

Eine vorteilhafte Weiterbildung der Erfindung besteht darin, daß jeweils die Verfahrensschritte f.) und g.) sowie h.) und i.) gleichzeitig durchgeführt werden. Ein derartig modifiziertes Verfahren würde somit schneller und mit weniger Verfahrensschritten ablaufen.

Weiterhin liegt es im Rahmen der Erfindung, daß nach Verfahrensschritt e.) die folgenden Verfahrensschritte mindestens einmal durchgeführt werden:
d'.) Auftragen einer weiteren Fotoresistschicht (8) auf die vorhergehenden Fotoresistschichten (2,5) und auf das Substrat (1) im Bereich der Öffnung (4);
e'.) Erzeugen einer weiteren Öffnung (10) in der weiteren Fotoresistschicht (8) durch Belichten durch eine Maske (9), Entwickeln und Post-Bake, wobei die weitere Öffnung (10) über der Öffnung (7) der darunterliegenden Fotoresistschicht (5) angeordnet und größer als diese Öffnung (7) ist;
   und daß nach Verfahrensschritt h.) die folgenden Verfahrensschritte mindestens einmal durchgeführt werden:
g'.) Entfernen von Fotoresistschicht (2), soweit diese nicht von darüberliegender Fotoresistschicht (7) bedeckt war und gleichzeitiges Entfernen der obersten Fotoresistschicht (5);
h'.) Übertragen der weiteren Öffnung (10) in das Substrat (1) und gleichzeitig Vertiefen der vorhandenen Öffnungen (4,7) in dem Substrat (1).

Auf diese Weise können beliebig viele Stufen in das Substrat eingebracht werden.

Wird die Erfindung z.B zum Herstellen von Leiterzügen für Computerbauteile verwendet, kann es sinnvoll sein, daß die erste Öffnung (4) durch das Substrat (1) hindurch vertieft wird.

Im folgenden wird die Erfindung anhand von Zeichnungen detailliert beschrieben. Obwohl die Erfindung in allen Bereichen der Technik, in denen eine mehrstufige Struktur in einem Substrat erzeugt wird, Verwendung finden kann, soll sie hier anhand eines Beispiels aus der Fertigung von Computerbauteilen dargestellt werden.

Es zeigt
- Fig. 1a:: eine perspektivische Darstellung einer mehrstufigen Struktur, die mit dem erfindungsgemäßen Verfahren erzeugt werden kann
- Fig. 1b :: eine entlang der Linie A-A geschnittene Darstellung der Struktur aus Fig. la
- Fig. 2 :: ein möglicher Verfahrensablauf zum erfindungsgemäßen Herstellen einer zweistufigen Struktur
- Fig. 3 :: ein möglicher Verfahrensablauf zum erfindungsgemäßen Herstellen einer dreistufigen Struktur.

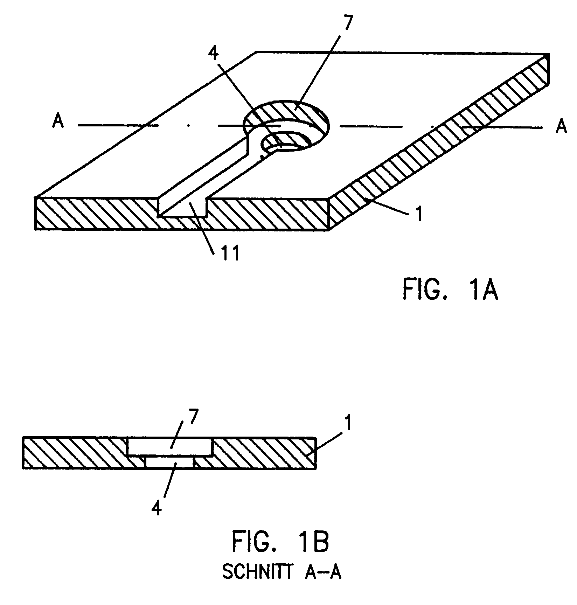

In den Figuren 1a und 1b ist eine nach dem erfindungsgemäßen Verfahren in einem Substrat 1 erzeugte stufige Struktur dargestellt. In dem Substrat 1 liegt eine erste Öffnung 4 vor, die in eine zweite Öffnung 7 mündet, wobei die Öffnung 7 weiter als die Öffnung 4 ist. An die Öffnung 7 schließt sich ein Graben 11 an, der gleichzeitig mit dieser in das Substrat eingebracht wird. Die Öffnungen 4 und 7 sind als sich durch das Substrat 1 erstreckend und jeweils etwa gleich tief ins Substrat 1 eingebracht dargestellt, obwohl mit dem erfindungsgemäßen Verfahren auch nichtdurchgehende, gras-und debrisfreie Öffnungen in ein Substrat eingebracht werden können, wobei die Tiefe und auch die Form jeder Öffnung im Substrat nahezu frei gewählt werden kann.

Auf dem Gebiet der Fertigung von Computerbauteilen werden solche mehrstufigen Strukturen u.a. bei Verdrahtungsebenen von Halbleiterchips und bei der Dünnfilm-Verdrahtung von Vielschicht-Keramik-Substraten erzeugt. Beispielsweise liegt gemäß den Figuren 1a und 1b dann ein dielektrisches Substrat 1 vor, in das ein Graben 11, der, wenn mit leitender Substanz aufgefüllt, einen Leiterzug darstellt, eingebracht ist. Dieser Leiterzug muß über ein sogenanntes Via, also die mit leitender Substanz aufgefüllten Öffnungen 4 und 7, mit einem darunterliegenden Leiterzug verbunden werden.

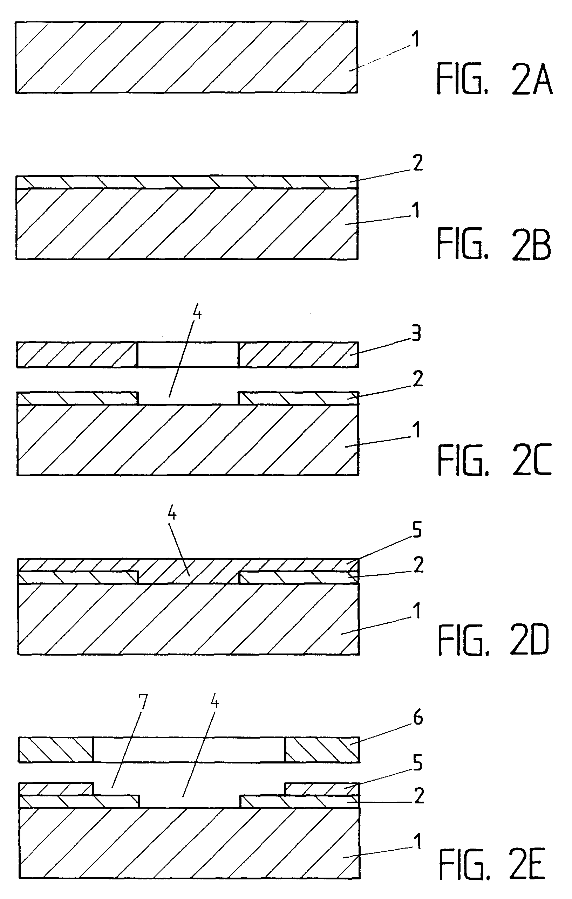

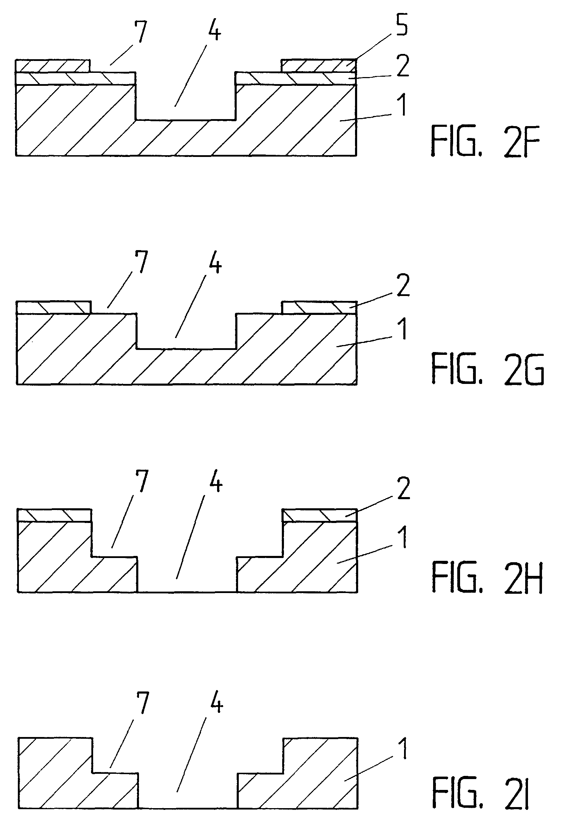

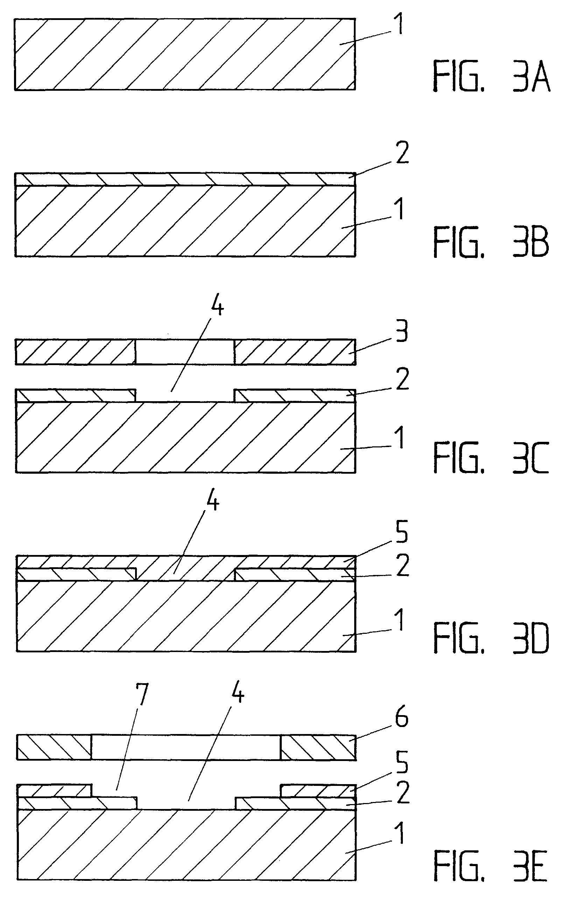

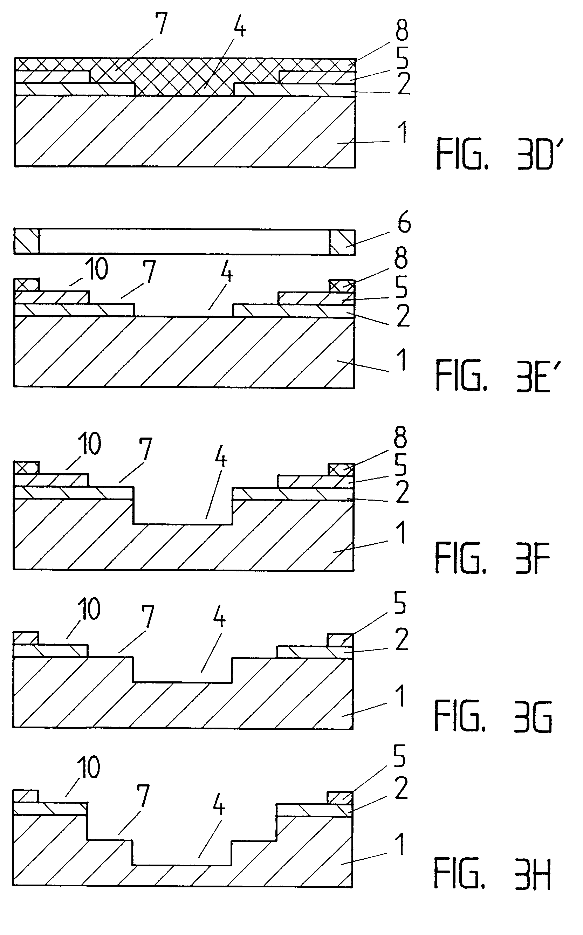

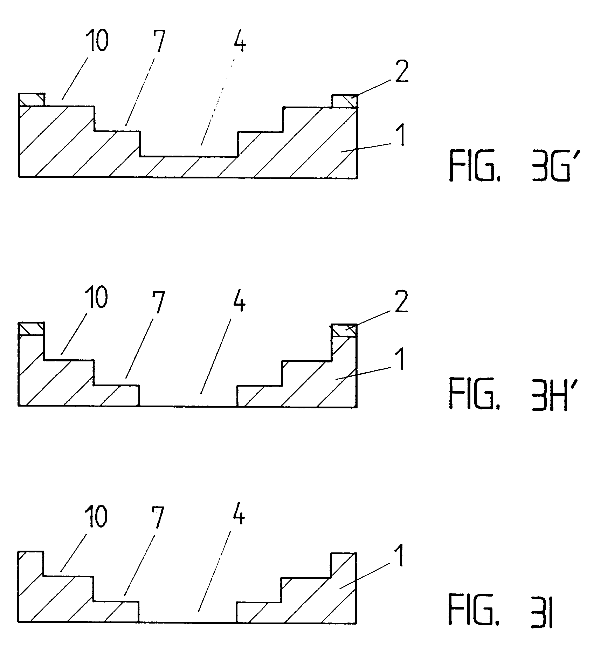

Die Figuren 2 und 3 zeigen die zum Erzeugen einer derartigen Struktur nach dem erfindungsgemäßen Verfahren erforderlichen Verfahrensschritte. Fig. 2 zeigt ein Verfahren zum Erzeugen einer zweistufigen Struktur und Fig. 3 eines zum Erzeugen einer Struktur mit mehr als zwei Stufen am Beispiel einer dreistufigen Struktur. Das Substrat 1 aus Schritt a.) kann aus organischem oder aus anorganischem Material bestehen, es muß lediglich durch ein mechanisches, physikalisches oder chemisches Verfahren abtragbar sein, das nicht gleichzeitig die Fotoresistschichten angreift. Aufgrund der relativ hohen Selektivität beim Abtragen gegenüber den bekannten Fotoresisten bieten sich organische Substratmaterialien an. Unter diesen kommen zahlreiche polymerisierte und unpolymerisierte Werkstoffe in Frage, Polyimid z.B. ist besonders geeignet. Ist die ursprüngliche Oberfläche nicht geeignet, so kann das Substrat 1 auf diese in Form einer gleichmäßigen Schicht aufgetragen werden.

Dies ist zum Beispiel bei der Herstellung von Mehrschicht-Keramik-Substraten der Fall. Dort wird auf das gesinterte Glas-Keramik-Substrat als Substrat 1 beispielsweise eine Schicht Polyimid aufgebracht und eventuell im festen Zustand planarisiert, z.B. durch Micromilling.

Liegt nun ein Substrat 1 mit ebener Oberfläche vor, wird auf dieses eine erste Fotoresistschicht 2 aufgebracht (Schritt b.)). Die Wahl des Fotoresists ist vom Substrat 1 und von dem Verfahren zum Abtragen des Substrats 1 abhängig. Der Fotoresist muß einerseits gut auf dem Substrat 1 haften, andererseits sollte er zumindest zu Beginn des Abtragens des Substrats 1 nicht angegriffen werden. Es kommen Flüssig- oder Trockenresiste, die positiv oder negativ arbeiten, in Frage.

Für den Fall der Mehrschicht-Keramik-Substrate wird z.B. ein herkömmlicher positiv arbeitender Fotoresist verwendet. Es kann sich als vorteilhaft erweisen, mit einem sylilierten Fotoresist zu arbeiten oder einen Positivlack nach dem Auftragen zu sylilieren, insbesonders wenn ein organisches Substratmaterial vorliegt.

Im darauffolgenden Verfahrensschritt c.) wird nun die Fotoresistschicht 2 durch eine erste Maske 3, die mindestens eine Öffnung aufweist, belichtet und anschließend entwickelt und ein Post-Bake-Schritt durchgeführt.

Auf diese an sich bereits abarbeitbare erste Fotoresistschicht 2 wird auch im Bereich der so entstandenen ersten Öffnung 4 im Schritt d.) eine zweite Fotoresistschicht 5 aufgetragen. Diese zweite Fotoresistschicht 5 kann aus dem gleichen oder einem verschiedenen Material wie die erste Fotoresistschicht 2 bestehen. Die Dicke der einzelnen Fotoresistschichten kann unterschiedlich sein.

Auch in der zweiten Fotoresistschicht 5 wird durch Belichten durch eine zweite Maske 6, Entwickeln und Post-Bake mindestens eine zweite Öffnung 7 erzeugt, die zumindest teilweise über einer ersten Öffnung 4 angeordnet und größer als diese erste Öffnung 4 ist (Schritt e.)). Auf diese Weise entsteht eine Doppelschicht, deren erste Öffnung 4 z.B. dem späteren Via und deren zweite Öffnung 7 z.B. dem späteren Leiterzug entspricht.

Sollen mehr als zwei Stufen in das Substrat eingebracht werden, so werden die Schritte d.) und e.) weitere Male nacheinander durchgeführt (Schritte d'.) und e'.) in Fig. 3) und so beliebig viele übereinanderliegende Fotoresistschichten mit Öffnungen erzeugt. Die auf diese Weise erzeugte Doppel- bzw. Mehrfachschicht wird in den folgenden Verfahrensschritten sequentiell abgearbeitet.

Zunächst wird die erste Öffnung 4 in das Substrat 1 übertragen (Schritt f.)). Dies erfolgt mit einem zum Abtragen von Substrat 1 geeigneten mechanischen, chemischen oder physikalischen Abtragungsverfahren. Dies kann z.B. ein chemisches oder physikalisches Ätzverfahren sein. So ist es beispielsweise möglich, ein aus Polyimid bestehendes Substrat 1 durch gegenüber den Fotoresistschichten äußerst selektive und uniforme Trockenätzschritte debris- und grasfrei mit hoher Ätzrate abzutragen. Mit einem Sauerstoffplasma kann beispielsweise eine Uniformität von besser als 5% erreicht werden, wodurch eine Ätzstopschicht vermieden werden kann.

Nun wird die erste Fotoresistschicht 2, soweit sie nicht von darüberliegender zweiter Fotoresistschicht 5 bedeckt war, und gleichzeitig die zweite Fotoresistschicht 5 abgetragen (Schritt g.)). Es wird also das Muster der Fotoresistschicht 5 auf die Fotoresistschicht 2 übertragen. Dafür ist wiederum jedes Abtragungsverfahren prinzipiell geeignet, am zweckmäßigsten ist es jedoch bei der oben beschriebenen Materialkonstellation, das Ätzgas zu wechseln und mit einem Ätzgas zu arbeiten, das eine Fluorverbindung, wie z.B. CF₄, enthält. Mit einem solchen Ätzgas kann die Fotoresistschicht, auch wenn sie syliliert ist, mit hoher Uniformität abgetragen werden.

Anschließend wird in Schritt h.) die zweite Öffnung 7 in das Substrat 1 übertragen und die erste Öffnung 4 weiter in das Substrat 1 bis zur jeweils gewünschten Tiefe hineingetrieben. Je nach Verwendungszweck der stufigen Struktur kann es sinnvoll sein, die erste Öffnung 4 durch das Substrat 1 hindurchzutreiben, so z.B. für Leiterbahnen mit einem Via, das diese mit darunterliegenden Leiterbahnen verbindet. Es besteht selbstverständlich auch die Möglichkeit, daß die zweite Öffnung als Leiterbahn strukturiert und als solche in das Substrat übertragen wird. Für den Schritt h.) wird in der Regel das gleiche Abtragungsverfahren wie für den Schritt f.) Anwendung finden.

Falls mehr als zwei Fotoresistschichten aufgebracht und strukturiert wurden, werden diese nun durch entsprechendes Wiederholen der Verfahrensschritte g.) und h.) als zusätzliche Stufen in das Substrat übertragen und dann vertieft (Schritte g'.) und h'.) in Fig. 3).

In einem weiteren Verfahrensschritt i.) wird dann nach dem Abarbeiten der Doppel- bzw. Mehrfachschicht die verbleibende Fotoresistschicht 2 mit einem Abtragungsverfahren wie in Schritt g.) entfernt.

Es ist auch möglich, die Schritte f.) und g.) sowie die Schritte h.) und i.) gleichzeitig durchzuführen, indem man die dafür erforderlichen Abtragungsvorgänge kombiniert, z.B. durch Zumischen von bis etwa 3% einer Fluorverbindung wie CF₄ zu einem Sauerstoffplasma oder indem in reinem Sauerstoffplasma die Fotoresistschicht abgetragen wird.

Da für den dargestellten anisotropen Ätzprozeß lediglich durch ein Variieren der Ätzgase die verschiedenen Ätzvorgänge an den Fotoresistschichten und in dem Subtrat durchgeführt werden können, entfällt das Wechseln des Abtragungswerkzeugs. In einem bei sehr geringem Druck (unter 10 microbar) arbeitendem Plasmaätzreaktor neuerer Art, wie z.B. einem DECR(Distributed Electron Cyclotron Resonance)-Werkzeug können somit alle für die Durchführung des Verfahrens erforderlichen Ätzschritte durchgeführt werden, was kosten- und zeitsparend ist. Falls erforderlich, kann auch noch ein sogenannter Ion-Beam Etch zum Entfernen einer Chromschicht auf einem unter dem Substrat liegenden Pad im DECR-Werkzeug stattfinden. Eine Uniformität von ca. 1,5% und besser kann mit dem DECR-Werkzeug erreicht werden.

Durch die Verlagerung der Topographieproblems, das beim Erzeugen kleinster stufiger Strukturen bisher auftrat, auf dünne, auf einer glatten Oberfläche aufzubringende Schichten, die dann selektiv abgearbeitet werden, können auch kleinste stufige Strukturen hergestellt werden, wie sie z.B. mit Laser-Ablation nicht mehr machbar sind. Somit stellt das erfindungsgemäße Verfahren eine Möglichkeit dar, bisher bei Dünnfilm-Packaging-Produkten unerreichte Integrationsdichten zu erzielen.

## Patentansprüche

1. Verfahren zum Erzeugen einer mehrstufigen Struktur in einem Substrat, das folgende Verfahrensschritte aufweist:
a.) Herstellen eines Substrates (1);
b.) Auftragen einer ersten Fotoresistschicht (2) auf das Substrat (1);
c.) Erzeugen einer ersten Öffnung (4) in der ersten Fotoresistschicht (2) durch Belichten durch eine erste Maske (3), Entwickeln und Post-Bake der ersten Fotoresistschicht (2);
d.) Auftragen einer zweiten Fotoresistschicht(5) auf die erste Fotoresistschicht (2) und auf das Substrat (1) im Bereich der ersten Öffnung (4) wobei mindestens eine der Fotoresistschichten (2,5) aus Fotoresist besteht, der nach dem Auftragen silyliert wird oder daß mindestens einer der Fotoresistschichten als silylierter Fotoresist aufgetragen wird.
e.) Erzeugen einer zweiten Öffnung (7) in der zweiten Fotoresistschicht (5) durch Belichten durch eine zweite Maske (6), Entwickeln und Post-Bake, wobei die zweite Öffnung (7) über der ersten Öffnung (4) angeordnet und größer als die erste Öffnung (4) ist;
f.) Übertragen der ersten Öffnung (4) in das Substrat (1);
g.) Entfernen der ersten Fotoresistschicht (2), soweit diese nicht von darüberliegender zweiter Fotoresistschicht (5) bedeckt war und gleichzeitiges Entfernen der obersten Fotoresistschicht (5);
h.) Übertragen der zweiten Öffnung (7) in das Substrat (1) und gleichzeitig Vertiefen der ersten Öffnung (4) in dem Substrat (1);
i.) Entfernen der ersten Fotoresistschicht (2).

2. Verfahren gemäß Anspruch 1, dadurch gekennzeichnet, daß jeweils die Verfahrensschritte f.) und g.) sowie h.) und i.) gleichzeitig durchgeführt werden.

3. Verfahren gemäß Anspruch 1 oder 2, dadurch gekennzeichnet, daß nach Verfahrensschritt e.) die folgenden Verfahrensschritte mindestens einmal durchgeführt werden:
d'.) Auftragen einer weiteren Fotoresistschicht (8) auf die vorhergehenden Fotoresistschichten (2,5) und auf das Substrat (1) im Bereich der Öffnung (4);
e'.) Erzeugen einer weiteren Öffnung (10) in der weiteren Fotoresistschicht (8) durch Belichten durch eine Maske (9), Entwickeln und Post-Bake, wobei die weitere Öffnung (10) über der Öffnung (7) der darunterliegenden Fotoresistschicht (5) angeordnet und größer als diese Öffnung (7) ist; und daß nach Verfahrensschritt h.) die folgenden Verfahrensschritte mindestens einmal durchgeführt werden:
g'.) Entfernen von Fotoresistschicht (2), soweit diese nicht von darüberliegender Fotoresistschicht (5) bedeckt war und gleichzeitiges Entfernen der obersten Fotoresistschicht (5);
h'.) Übertragen der weiteren Öffnung (10) in das Substrat (1) und gleichzeitig Vertiefen der vorhandenen Öffnungen (4,7) in dem Substrat (1).

4. Verfahren gemäß einem oder mehreren der Ansprüche 1 - 3, dadurch gekennzeichnet, daß die erste Öffnung (4) durch das Substrat (1) hindurch vertieft wird.

5. Verfahren gemäß einem oder mehreren der vorhergehenden Ansprüche, dadurch gekennzeichnet, daß das Substrat (1) aus organischem Material, vorzugsweise aus einem organischen Polymer, insbesonders Polyimid, besteht.

6. Verfahren gemäß einem oder mehreren der vorhergehenden Ansprüche, dadurch gekennzeichnet, daß das Übertragen der Öffnungen (4,7,10) durch Ätzvorgänge erfolgt und das Ätzgas für die Ätzvorgänge f.) und h.) sowie h'.) Sauerstoff enthält.

7. Verfahren gemäß einem oder mehreren der vorhergehenden Ansprüche, dadurch gekennzeichnet, daß das Erzeugen der Öffnungen (4,7,10) durch Ätzvorgänge erfolgt und das Ätzgas für die Ätzvorgänge g.) und i.) sowie g'.) eine Fluorverbindung, insbesonders CF₄, enthält.

8. Verfahren gemäß einem oder mehreren der Ansprüche 2-5, dadurch gekennzeichnet, daß das Ätzgas für die Verfahrensschritte f.), g.) und g'.) sowie h.), i.) und h'.) jeweils Sauerstoff und eine Fluorverbindung, insbesonders CF₄, enthält.

9. Verfahren gemäß Anspruch 9, dadurch gekennzeichnet, daß das Ätzgas für die Verfahrensschritte f.), g.) und g'.) sowie h.), i.) und h'.) jeweils Sauerstoff und etwa 0-3% einer Fluorverbindung, insbesonders CF₄, enthält.

## Claims

1. Method for producing a multi-step structure in a substrate, comprising the steps of:
a) producing a substrate (1);
b) depositing a first photoresist layer (2) on the substrate (1);
c) forming a first opening (4) in the first photoresist layer (2) by exposure through a first mask (3), development and postbaking of the first photoresist layer (2);
d) depositing a second photoresist layer (5) on the first photoresist layer (2) and on the substrate (1) in the area of the first opening (4), wherein at least one of the photoresist layers (2, 5, 8) consists of photoresist which is silylated after depositing, or at least one of the photoresist layers is deposited as silylated photoresist;
e) forming a second opening (7) in the second photoresist layer (5) by exposure through a second mask (6), development and postbaking, with said second opening (7) overlying and being larger than the first opening (4);
f) transferring the first opening (4) to the substrate (1);
g) removing the first photoresist layer (2) to the extent to which it is not covered by the overlying second photoresist layer (5) and simultaneously removing the top-most photoresist layer (5);
h) transferring the second opening (7) to the substrate (1) and simultaneously deepening the first opening (4) in the substrate (1);
i) removing the first photoresist layer (2).

2. Method according to claim 1, characterized in that steps f) and g) and h) and i) are carried out simultaneously.

3. Method according to claim 1 or 2, characterized in that after completion of step e), the following steps are carried out at least once:
d') depositing a further photoresist layer (8) on the existing photoresist layers (2, 5) and on the substrate (1) in the area of opening (4);
e') forming a further opening (10) in the further photoresist layer (8) by exposure through a mask (9), development and postbaking, with said further opening (10) overlying and being larger than the opening (7) in photoresist layer (5); and that after completion of step h), the following steps are carried out at least once:
g') removing photoresist layer (2) to the extent to which it is not covered by the overlying photoresist layer (5) and simultaneously removing the top-most photoresist layer (5);
h') transferring the further opening (10) to the substrate (1) and simultaneously deepening the existing openings (4, 7) in the substrate (1).

4. Method according to any one or several of the claims 1 to 3, characterized in that the first opening (4) is formed to extend through the substrate (1).

5. Method according to any one or several of the preceding claims, characterized in that the substrate (1) consists of organic material, preferably an organic polymer, in particular polyimide.

6. Method according to any one or several of the preceding claims, characterized in that the openings (4, 7, 10) are transferred by etch steps and the etch gas for the etch steps f) and h) as well as h') contains oxygen.

7. Method according to any one or several of the preceding claims, characterized in that the openings (4, 7, 10) are produced by etch steps and the etch gas for the etch steps g) and i) as well as g') contains a fluorine compound, in particular CF₄.

8. Method according to any one or several of the claims 2 to 5, characterized in that the etch gas for the method steps f), g) and g') as well as h), i) and h') contains oxygen and a fluorine compound, in particular CF₄.

9. Method according to claim 9, characterized in that the etch gas for the method steps f), g) and g') as well as h), i) and h') contains oxygen and about 0-3% of a fluorine compound, in particular CF₄.

## Revendications

1. Procédé pour fabriquer une structure en échelon dans un substrat, présentant les étapes de procédé ci-après :
a.) Fabrication d'un substrat (1) ;
b.) Application d'une première couche photorésist (2) sur le substrat (1) ;
c.) Réalisation d'une première ouverture (4) dans la première couche photorésist (2) par illumination au moyen d'un premier masque (3), développement et post-cuisson de la première couche photorésist (2) ;
d.) Application d'une deuxième couche photorésist (5) sur la première couche photorésist (2) et sur le substrat (1) dans la zone de la première ouverture (4), au moins l'une des couches photorésist (2, 5) étant constituée d'un photorésist qui est silylé après application, ou bien en ce qu'au moins l'une des couches photorésist est appliquée sous la forme d'un photorésist silylé ;
e.) Réalisation d'une deuxième ouverture (7) dans la deuxième couche de photorésist (5) par illumination au moyen d'un deuxième masque (6), développement et post-cuisson, la deuxième ouverture (7) étant disposée au-dessus de la première ouverture (4) et étant de taille supérieure à celle de la première ouverture (4);
f.) Transmission de la première ouverture (4) dans le substrat (1) ;
g.) Elimination de la première couche photorésist (2), dans la mesure où celle-ci n'était pas recouverte par la deuxième couche photorésist (5) placée sur elle, et enlèvement simultané de la couche photorésist (5) la plus au-dessus ;
h.) Transmission de la deuxième ouverture (7) dans le substrat (1) et creusement simultané de la première ouverture (4) dans le substrat (1) ;
i.) Enlèvement de la première couche photorésist (2).

2. Procédé selon la revendication 1, caractérisé en ce que chaque fois les étapes de procédé f.) et g.) ainsi que h.) et i.) sont effectuées simultanément.

3. Procédé selon la revendication 1 ou 2, caractérisé en ce que, après l'étape de procédé e.), les étapes de procédé suivantes sont effectuées au moins à une reprise :
d'.) Application d'une autre couche photorésist (8) sur les couches photorésist (2, 5) précédentes et sur le substrat (1) dans la zone de l'ouverture (4) ;
e'.) Réalisation d'une autre ouverture (10) dans l'autre couche photorésist (8) par illumination au moyen d'un masque (9), développement et post-cuisson, l'autre ouverture (10) étant disposée au-dessus de l'ouverture (7) de la couche photorésist (5) sous-jacente et étant de taille supérieure à cette ouverture (7) ;
et en ce que, après l'étape de procédé h.), les étapes de procédé ci-après sont effectuées à au moins une reprise :
g'.) Enlèvement de la couche photorésist (2), dans la mesure où celle-ci n'était pas recouverte par une couche photorésist (5) disposée dessus et enlèvement simultané de la couche photorésist (5) la plus au-dessus ;
h'.) Transmission de l'autre ouverture (10) dans le substrat (1) et creusement simultané des ouvertures (4, 7) existantes dans le substrat (1).

4. Procédé selon une ou plusieurs des revendications 1-3, caractérisé en ce que la première ouverture (4) est creusée dans le substrat (1).

5. Procédé selon une ou plusieurs des revendications précédentes, caractérisé en ce que le substrat (1) est constitué d'un matériau organique, de préférence d'un polymère organique, en particulier du polyimide.

6. Procédé selon une ou plusieurs des revendications précédentes, caractérisé en ce que la transmission des ouvertures (4, 7, 10) s'effectue par des processus de gravure-morsure et le gaz de gravure-morsure destiné aux processus de gravure-morsure f.) et h.) ainsi que h'.) contenant de l'oxygène.

7. Procédé selon une ou plusieurs des revendications précédentes, caractérisé en ce que la réalisation des ouvertures (4, 7, 10) s'effectue par des processus de gravure-morsure et le gaz de gravure-morsure destiné aux processus de gravure-morsure g.) et i.) ainsi que g'.) contenant une combinaison fluor, en particulier du CF₄.

8. Procédé selon une ou plusieurs des revendications 2-5, caractérisé en ce que le gaz de gravure-morsure destiné aux étapes de procédé f.), g.) et g'.), ainsi que h.), i.) et h'.) contient chaque fois de l'oxygène et une combinaison fluor, en particulier du CF₄.

9. Procédé selon la revendication 8, caractérisé en ce que le gaz de gravure-morsure destiné aux étapes de procédé f.), g.) et g'.) ainsi que h.), i.) et h'.) contient chaque fois de l'oxygène et environ 0-3% d'une combinaison fluor, en particulier CF₄.
